# NEUE EUROPÄISCHE PATENTSCHRIFT

(11) **EP 1 491 077 B2**
(45) Veröffentlichungstag und Bekanntmachung des Hinweises auf die Entscheidung über den Einspruch: **03.06.2009**
(45) Hinweis auf die Patenterteilung: 04.01.2006
(21) Anmeldenummer: 02792618.7
(22) Anmeldetag: 29.11.2002
(51) Int. Cl.: H05K 1/18

(54) **STEUERGERÄT**
CONTROL DEVICE
APPAREIL DE COMMANDE

(30) Priorität: 01.02.2002 DE 10204355
(43) Veröffentlichungstag der Anmeldung: 29.12.2004
(73) Patentinhaber: ROBERT BOSCH GMBH, 70442 Stuttgart (DE)
(72) Erfinder: DEPTULA, Piotr, 75428 Illingen (DE); BIRKLE, Werner, 71640 Ludwigsburg (DE); SCHENK, Joachim, 38536 Meinersen-Ohof (DE); WESSNER, Jochen, 73728 Esslingen (DE)
(86) Internationale Anmeldenummer: PCT/DE2002/004383
(87) Internationale Veröffentlichungsnummer: WO 2003/065777

(56) Entgegenhaltungen:
- EP-A- 0 722 264
- WO-A2-01/33926
- DE- - 2 418 954
- DE-A1- 3 934 790
- DE-A1- 3 943 261
- DE-A1- 19 514 078
- DE-A1- 19 539 584
- DE-A1- 19 832 560
- DE-A1- 19 953 191
- DE-U1- 20 003 951
- FR-A3- 2 806 217
- US- - 2 613 252
- US-A- 5 446 626
- ROBERT BOSCH GMBH: 'Kraftfahrtechnisches Taschenbuch', Bd. 23, 1999, SPRINGER-VERLAG, GERMANY, ISBN 3-528-03876-4 Artikel 'Bordnetz/Stromversorgung', Seiten 862 - 864

## Beschreibung

### Stand der Technik

Die Erfindung betrifft ein Steuergerät mit einem Leistungsteil und einem Elektronikteil, wobei der Leistungsteil Bauelemente umfasst, die mit höheren Strömen, insbesondere mit Strömen im Bereich 5A bis 70A, beaufschlagt werden, und wobei der Elektronikteil eine auf einer Leiterplatte realisierte Schaltungslogik umfasst.

Bei Bordnetzsteuergeräten von Kraftfahrzeugen handelt es sich in der Regel um Steuergeräte der eingangs genannten Art. Der Leistungsteil umfasst alle Bauelemente, die mit höheren Strömen, d.h. mit Strömen zwischen 5A und 70A, beaufschlagt werden, wie z.B. Relais und Sicherungen der Scheibenheizung , des Horns, etc.. Die Verbindungen zwischen den Bauelementen des Leistungsteils müssen für diese hohen Ströme ausgelegt sein. In der Praxis haben sich Stanzstreifen aus einem viellagigen Stanzgitter als Verbindungsbahnen des Leistungsteils bewährt. Zumindest für einen Teil der Bauelemente, wie z.B. die Relais, sind zusätzliche Kontaktierungselemente vorgesehen, beispielsweise in Form von auf das Stanzgitter gelöteten oder geschweißten Kontakten. Die Pins der externen Leistungsteilstecker werden häufig singulär ausgeführt. Der Bauraumbedarf und der Materialverbrauch dieser Variante sind relativ hoch, was zu relativ hohen Herstellungs- und Assemblagekosten führt. Der Elektronikteil umfasst die Schaltungslogik für den Leistungsteil. Die Strombelastung liegt hier in der Regel im Bereich bis zu 2A. Die Schaltungslogik und auch die dazugehörigen Verbindungen werden üblicherweise in Form einer Leiterplatte mit geätzten Bahnstrukturen realisiert. Die elektrische Verbindung zwischen dem Leistungsteil und dem Elektronikteil ist in der Regel über eine Lötverbindung zwischen entsprechenden Kontaktstellen der beiden Einheiten realisiert. Über diese Lötverbindung werden zum einen Steuersignale von der Schaltungslogik zum Leistungsteil übertragen, die beispielsweise die Relais schalten, und zum anderen Feedback-Signale vom Leistungsteil, z.B. von den Relais, zurück zur Leiterplatte bzw. Schaltungslogik.

Allgemeiner Stand der Technik ist hierzu die deutsche Offenlegungsschrift DE 43 23 827 C1. Aus dieser Schrift ist eine steckbare Baugruppe bekannt, die eine als Formteil aus Kunststoff gebildete Leiterplatte aufweist, in welcher aus mindestens einem Stanzgitter gebildete Leiterbahnen eingebettet sind. Auf dieser Leiterplatte sind über diese Leiterbahnen elektrisch verbundene Bauelemente befestigt.

### Vorteile der Erfindung

Mit der vorliegenden Erfindung wird ein Steuergerät der eingangs genannten Art vorgeschlagen, das modular aufgebaut ist, indem der Leistungsteil und der Elektronikteil baulich voneinander getrennt sind. Das erfindungsgemäße Konzept ermöglicht außerdem eine deutliche Reduzierung des für den Leistungsteil erforderlichen Bauraums bei vermindertem Materialeinsatz, Herstellungs- und Assemblageaufwand. Dementsprechend kann das erfindungsgemäße Steuergerät mit einer relativ geringen Baugröße, relativ geringem Gewicht und auch relativ kostengünstig realisiert werden.

Dies wird erfindungsgemäß dadurch erreicht, dass die elektrischen Verbindungen zwischen den Bauelementen des Leistungsteils durch ein einlagiges Stanzgitter realisiert sind. In dem Stanzgitter sind Aufnahmen für die Kontaktstifte der Bauelemente ausgebildet, und zwar so, dass die Bauelemente über die Kontaktstifte reibschlüssig in den Aufnahmen gehalten und elektrisch kontaktiert werden.

Der Erfindung liegt die Erkenntnis zugrunde, dass höhere Ströme, wie sie im Leistungsteil eines Steuergeräts der hier in Rede stehenden Art auftreten, auch über Stanzstreifen eines einlagigen Stanzgitters geführt werden können. Erfindungsgemäß wird daher vorgeschlagen, mit Hilfe eines entsprechenden Layouts sämtliche elektrischen Verbindungen zwischen den Bauelementen des Leistungsteils in einem einlagigen Stanzgitter auszubilden. Außerdem ist erkannt worden, dass sich durch geschickten Einsatz der Stanzgittertechnik bereits in einem einlagigen Stanzgitter eine hohe Funktionalität realisieren lässt. Erfindungsgemäß wird daher vorgeschlagen, zusätzlich zu den elektrischen Verbindungen auch Aufnahmen für die Kontaktstifte der Bauelemente in dem einlagigen Stanzgitter auszubilden. Die Kontaktstifte der Bauelemente werden direkt - ohne zusätzliche Kontaktierungselemente - in diese Aufnahmen des Stanzgitters eingesteckt, wo sie reibschlüssig gehalten und elektrisch kontaktiert werden. Auf diese Weise können alle Ein- und Ausgänge der Bauelemente des Leistungsteils stanzgitterseitig realisiert werden. Das Stanzgitter dient hier also nicht nur der Herstellung von elektrischen Verbindungen zwischen den Bauelementen des Leistungsteils sondern auch als Träger für die elektrischen Bauelemente. Durch den erfindungsgemäßen Einsatz eines einlagigen Stanzgitters zur Realisierung der elektrischen Verbindungen zwischen den Bauelementen und durch den Verzicht auf zusätzliche Kontaktierungselemente für die Bauelemente reduziert sich nicht nur der für den Leistungsteil erforderliche Bauraum wesentlich sondern auch der Materialaufwand und in Folge das Gewicht des gesamten Steuergeräts.

Grundsätzlich gibt es verschiedene Möglichkeiten für die Realisierung des erfindungsgemäßen Steuergeräts und insbesondere für die Realisierung des Stanzgitters mit den Aufnahmen für die Kontaktstifte der Bauelemente des Leistungsteils.

Im Hinblick auf eine einfache Assemblage des Leistungsteils und insbesondere einen unkomplizierten Austausch von defekten Bauelementen ist erfindungsgemäß die Verbindung zwischen den Kontaktstiften eines Bauelements und den entsprechenden Aufnahmen im Stanzgitter reversibel herstellbar und wieder lösbar. Erfindungsgemäß, sind die Aufnahmen für die Kontaktstifte in Form von Stanzlöchern im Stanzgitter realisiert. Im Randbereich eines solchen Stanzlochs sind mindestens zwei, vorzugsweise drei, nach innen gerichtete Haltenasen ausgebildet, und zwar so, dass die Haltenasen eine Klemmwirkung auf einen in das Stanzloch eingesteckten Kontaktstift ausüben. Die Klemmwirkung wird dadurch verbessert, dass die Haltenasen beim Einstecken des Kontaktstifts deformiert werden. Erfindungsgemäß sind die Haltenasen elastisch deformierbar, da die Bauelemente des Leistungsteils in diesem Fall einfach ausgetauscht werden können, ohne dass Probleme bei der elektrischen Kontaktierung über das Stanzgitter zu befürchten sind. Die voranstehend beschriebenen Varianten einer Aufnahme für einen Kontaktstift sind auch deshalb vorteilhaft, weil sie sich einfach in Stanzgittertechnik realisieren lassen.

In einer vorteilhaften Weiterbildung des der Erfindung zugrunde liegenden Konzepts für die Realisierung des Leistungsteils eines Steuergeräts wird die Funktionalität des einlagigen Stanzgitters zusätzlich dadurch erhöht, dass in dem Stanzgitter auch Kontaktierungselemente für die Leiterplatte des Elektronikteils ausgebildet werden. Die elektrische Kontaktierung zwischen dem Leistungsteil und dem Elektronikteil kann in diesem Fall einfach durch partielles Verlöten der im Stanzgitter ausgebildeten Kontaktierungselemente mit entsprechenden Kontaktierungsstellen der Leiterplatte realisiert werden. Hierfür sind keine zusätzlichen Hilfskonstruktionen erforderlich. Bei dieser Variante werden auch die Steuersignale der Schaltungslogik über das Stanzgitter, nämlich die Kontaktierungselemente für die Leiterplatte des Elektronikteils, zu den Bauelementen des Leistungsteils übertragen, so wie deren Feedback-Informationen über die im Stanzgitter ausgebildeten Kontaktierungselemente zurück zur Schaltungslogik übertragen werden.

Die Funktionalität des einlagigen Stanzgitters kann alternativ oder zusätzlich zu der voranstehend beschriebenen Variante auch durch Ausbildung von Steckerpins für mindestens einen externen Leistungsteilstecker erhöht werden. In diesem Fall werden auch die an den Leistungsteil angeschlossenen externen Verbraucher im Hochstrombereich über das Stanzgitter, nämlich die im Stanzgitter ausgebildeten Steckerpins der externen Leistungsteilstecker, angesteuert.

### Zeichnung

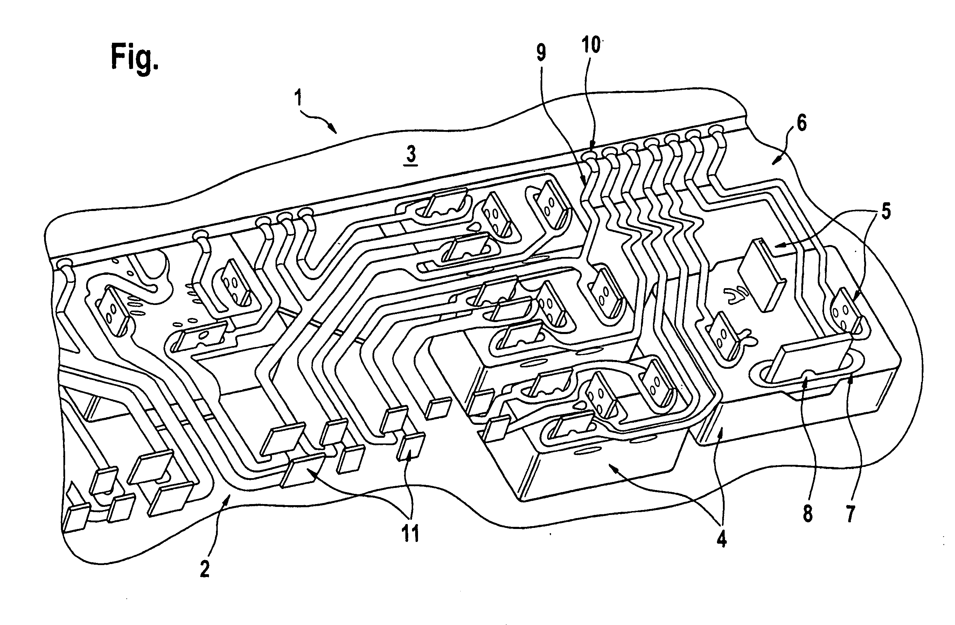

Wie bereits voranstehend ausführlich erörtert, gibt es verschiedene Möglichkeiten, die Lehre der vorliegenden Erfindung in vorteilhafter Weise auszugestalten und weiterzubilden. Dazu wird einerseits auf die dem Patentanspruch 1 nachgeordneten Patentansprüche und andererseits auf die nachfolgende Beschreibung eines Ausführungsbeispiels der Erfindung anhand der Zeichnung verwiesen.

Die einzige Figur zeigt eine perspektivische Teildarstellung des Leistungsteils und des Elektronikteils eines erfindungsgemäßen Steuergeräts.

### Beschreibung des Ausführungsbeispiels

Bei dem in der einzigen Figur ausschnittsweise dargestellten Steuergerät handelt es sich um das Bordnetzsteuergerät eines Kraftfahrzeugs. Es umfasst zwei Haupteinheiten, den Elektronikteil 1 und den Leistungsteil 2.

Der Elektronikteil 1 umfasst die Schaltungslogik für den Leistungsteil 2. Die Strombelastung liegt hier im Bereich bis zu 2A. Die gesamte Schaltungslogik ist auf einer Leiterplatte 3 realisiert, wobei die zugehörigen Verbindungen durch geätzte Bahnstrukturen gebildet sind.

Die Leiterplatte 3 ist in einem Elektronikgehäuse angeordnet, das hier nicht dargestellt ist. Die Leiterplatte 3 wird über Zentrierstifte in dem Elektronikgehäuse positioniert und über Rasthaken an den Seiten der Leiterplatte 3 gehalten. Auf der Außenseite des Elektronikgehäuses sind Stecker angeordnet, die der Kontaktierung und Signalübertragung zum externen Kabelbaum hin dienen. Der Kabelbaumstecker kann in. Einrastposition über einen Sekundärverriegelungsschieber zusätzlich gehalten und auf Positionsrichtigkeit abgefragt werden.

Im Leistungsteil 2 sind alle Bauelemente 4 vereint, die mit höheren Strömen beaufschlagt werden, d.h. mit Strömen I der Größenordnung 5A < 1 < 70A. Dabei handelt es sich beispielsweise um Relais und Sicherungen für die Scheibenheizung oder das Horn.

Erfindungsgemäß sind die elektrischen Verbindungen zwischen den Bauelementen 4 des Leistungsteils 2 durch ein einlagiges Stanzgitter 6 realisiert. In dem Stanzgitter 6 sind außerdem Aufnahmen 7 für die Kontaktstifte 5 der Bauelemente 4 ausgebildet. Die Bauelemente 4 werden über ihre Kontaktstifte 5 reibschlüssig in den Aufnahmen 7 gehalten und elektrisch kontaktiert.

Im hier dargestellten Ausführungsbeispiel sind die Aufnahmen 7 für die Kontaktstifte 5 der Bauelemente 4 in Form von Stanzlöchern im Stanzgitter 6 realisiert, Die Stanzlöcher haben eine im wesentlichen halbkreisförmige Grundform. Im Randbereich jedes Stanzlochs sind drei nach innen gerichtete Haltenasen 8 ausgebildet. Zwei der Haltenasen 8 sind an der gekrümmten Innenkante des Stanzlochs angeordnet, während die dritte Haltenase 8 mittig zwischen diesen beiden Haltenasen 8 an der gegenüberliegenden geraden Innenkante des Stanzlochs angeordnet ist. Die Haltenasen 8 sind elastisch deformierbar. Sie werden beim Einstecken eines Kontaktstifts 5 aus der Ebene des Stanzgitters 6 herausgedrückt. Dabei üben sie eine Klemmwirkung auf den Kontaktstift 5 aus, die eine sichere reibschlüssige Befestigung und eine zuverlässige elektrische Kontaktierung des Bauelements 4 über das Stanzgitter 6 gewährleistet. Aufgrund der elastischen Deformierbarkeit der Haltenasen 8 können die Bauelemente 4 auch jeder Zeit problemlos ausgewechselt werden.

Auch die elektrische Schnittstelle zwischen dem Leistungsteil 2 und dem Elektronikteil 1 ist im hier dargestellten Ausführungsbeispiel mit Hilfe des Stanzgitters 6 realisiert. Dazu sind im Stanzgitter 6 Kontaktierungselemente 9 für die Leiterplatte 3 des Elektronikteils 1 ausgebildet. Bei den Kontaktierungselementen 9 handelt es sich um Pins, die aus der Ebene des Stanzgitters 6 herausgebogen sind und mit entsprechenden Kontaktierungsstellen 10 der Leiterplatte 3 verlötet sind. Außerdem sind auch die Steckerpins 11 für die externen Leistungsteilstecker aus dem Stanzgitter 6 geformt.

Wie die Leiterplatte 3 des Elektronikteils 1 so ist auch das Stanzgitter 6 mit den Bauelementen 4 des Leistungsteils 2 in einem Gehäuse angeordnet, das hier ebenfalls nicht dargestellt ist. Das Leistungsteilgehäuse besteht aus einer Grundplatte und einer Abdeckung, die beispielsweise miteinander verklipst sein können, so dass die Bauelemente 4 des Leistungsteils einfach zugänglich sind. Das Stanzgitter 6 mit den Bauelementen 4 ist zwischen die beiden Gehäuseteile eingelegt und wird dort formschlüssig unter Berücksichtigung von Toleranzausgleichsanforderungen gehalten.

Die Steckerpins 11 für die externen Leistungsteilstecker ragen aus der Grundplatte des Leistungsteilgehäuses heraus und bilden zusammen mit den auf der Außenseite der Grundplatte realisierten Kunststoffaufnahmen den Gerätesteckerkragen. Analog zum Elektronikteil 1 kann auch hier ein Verriegelungsschieber zur Abfrage der Kabelbaumsteckerposition vorgesehen sein.

Zusammenfassend kann festgestellt werden, dass das erfindungsgemäße Steuergerätekonzept einen modularen Aufbau mit einer klaren Trennung zwischen Elektronikteil und Leistungsteil unterstützt. Der für das Leistungsteil benötigte Bauraum kann aufgrund der erfindungsgemäßen Maßnahmen auf ein Minimum reduziert werden, was mit deutlichen Materialeinsparungen gegenüber bekannten Steuergeräterealisierungen verbunden ist. Dadurch reduziert sich auch der Herstellungs- und Assemblageaufwand.

Die Hauptkomponente des erfindungsgemäßen Konzepts bildet ein einlagiges Stanzgitter, dem im Rahmen des Leistungsteils mehrere Funktionen zukommen. So dient das Stanzgitter - wie auch bei konventioneller Aufbautechnik - zur Realisierung der elektrischen Verbindungen der Bauelemente des Leistungsteils untereinander. Gleichzeitig bildet das Stanzgitter aber auch den Träger für diese Bauelemente. Dabei kommen - im Gegensatz zur konventionellen Aufbautechnik - keine zusätzlichen Hilfselemente zum Einsatz. Zusätzlich kann mit Hilfe des Stanzgitters auch die elektrische Kontaktierung zwischen Leistungstell und Elektronikteil realisiert werden. Des Weiteren können auch noch alle Steckerpins der externen Leistungsteilstecker im Stanzgitter ausgebildet werden. Dementsprechend kommt dem Stanzgitter im Rahmen des erfindungsgemäßen Konzepts eine integrierende Funktion zwischen Leistungsteil und Elektronikteil, den Bauelementen, wie Relais, und der externen Ansteuerung über den Leistungsteilstecker zu.

## Patentansprüche

1. Steuergerät mit einem Leistungsteil (2) und einem Elektronikteil (1), wobei der Leistungsteil (2) Bauelemente (4) umfasst, die mit höheren Strömen, insbesondere mit Strömen im Bereich 5A bis 70A, beaufschlagt werden, und wobei der Elektronikteil (1) eine auf einer Leiterplatte (3) realisierte Schaltungslogik umfasst, **dadurch gekennzeichnet, dass** die elektrischen Verbindungen zwischen den Bauelementen (4) des Leistungsteils (2) durch ein einlagiges Stanzgitter (6) realisiert sind,
dass in dem Stanzgitter (6) Aufnahmen (7) für die Kontaktstifte (5) der Bauelemente (4) ausgebildet sind,
dass die Verbindungen zwischen den Kontaktstiften (5) eines Bauelements (4) und den entsprechenden Aufnahmen (7) im Stanzgitter (6) reversibel herstellbar und wieder lösbar sind,
dass die Aufnahmen (7) so angeordnet und ausgebildet sind, dass die Bauelemente (4) dereart über die Kontaktstifte (5) reibschlüssig in den Aufnahmen (7) gehalten und elektrisch kontaktiert werden, dass das Stanzgitter auch als Träger für die elektrischen Bauelemente dient,
dass die Aufnahmen (7) für einen Kontaktstift (5) in Form von Stanzlöchern im Stanzgitter (6) realisiert sind, in deren Randbereichen mindestens zwei nach innen gerichtete Haltenasen (8) ausgebildet sind,
und dass die Haltenasen (8) elastisch deformierbar sind.

2. Steuergerät nach Anspruch 1, **dadurch gekennzeichnet, dass** in dem Stanzgitter (6) Kontaktierungselemente (9) für die Leiterplatte (3) des Elektronikteils (1) ausgebildet sind.

3. Steuergerät nach Anspruch 2, **dadurch gekennzeichnet, dass** die elektrische Kontaktierung zwischen dem Leistungsteil (2) und dem Elektronikteil (1) durch partielles Verlöten der im Stanzgitter (6) ausgebildeten Kontaktierungselemente (9) mit entsprechenden Kontaktierungsstellen (10) der Leiterplatte (3) realisiert ist

4. Steuergerät nach einem der Ansprüche 1 bis 3, **dadurch gekennzeichnet, dass** in dem Stanzgitter (6) Steckerpins (11) fuer mindestens einen externen Leistungsteilstecker ausgebildet sind.

5. Verwendung eines Steuergeräts nach einem der Ansprüche 1 bis 4 als Bordnetzsteuergerät für ein Kraftfahrzeug.

## Claims

1. Control device having a power section (2) and an electronics section (1), the power section (2) comprising components (4) which are subjected to higher currents, in particular to currents in the range from 5 A to 70 A, and the electronics section (1) comprising circuit logic implemented on a printed circuit board (3), **characterized in that** the electrical connections between the components (4) of the power section (2) are implemented by a single-layered leadframe (6), **in that** receptacles (7) for the contact pins (5) of the components (4) are formed in the leadframe (6), **in that** the connections between the contact pins (5) of one component (4) and the corresponding receptacles (7) in the leadframe (6) can be produced reversibly and can be detached again, **in that** the receptacles (7) are arranged and designed such that the components (4) can be held in the receptacles (7) with frictional locking by means of the contact pins (5), and electrical contact can thereby be made with said components (4), such that the leadframe is also used as a mount for the electrical components, **in that** the receptacles (7) for a contact pin (5) are implemented in the form of stamped holes in the leadframe (6), at least two inwardly pointing holding lugs (8) being formed in the edge region of said stamped holes, and **in that** the holding lugs (8) are elastically deformable.

2. Control device according to Claim 1, **characterized in that** contact-making elements (9) for the printed circuit board (3) of the electronics section (1) are formed in the leadframe (6).

3. Control device according to Claim 2, **characterized in that** electrical contact is made between the power section (2) and the electronics section (1) by partially soldering the contact-making elements (9) formed in the leadframe (6) to corresponding contact-making points (10) on the printed circuit board (3).

4. Control device according to one of Claims 1 to 3, **characterized in that** plug pins (11) for at least one external power section plug are formed in the leadframe (6).

5. Use of a control device according to one of Claims 1 to 4 as an on-board power supply system control device for a motor vehicle.

## Revendications

1. Appareil de commande avec une partie de puissance (2), et une partie électronique (1), la partie de puissance (2) comprenant des composants (4) alimentés par des intensités plus élevées, notamment par des intensités de l'ordre de 5 A à 70 A, et la partie électronique (1) comprenant un circuit logique réalisé sur une carte de circuit imprimé (3),
**caractérisé en ce que**
les connexions électriques entre les composants (4) de la partie de puissance (2) sont réalisées par une grille estampée ayant une couche (6),
des logeurs (7) étant réalisés dans la grille estampée (6), pour les fiches de contact (5) des composants (4),
les liaisons entre les fiches de contact (5) d'un composant (4) et les logeurs correspondants (7) de la grille estampée (6) sont réalisés de manière réversible et sont de nouveau amovibles,
les logeurs (7) sont disposés et réalisés pour que les composants (4) soient tenus par les fiches de contact (5) par une liaison par frottement dans les logeurs (7) et qu'elles soient en contact électrique, la grille estampée servant également de support aux composants électriques,
les logeurs (7) pour une fiche de contact (5) sont réalisés sous la forme d'orifices emboutis dans la grille estampée (6), et au moins deux becs de retenue (8) dirigés vers l'intérieur sont réalisés dans les zones de bord, et
les becs de retenue (8) sont déformables élastiquement.

2. Appareil de commande selon la revendication 1,
**caractérisé en ce que**
des éléments de contact (9) pour la plaque de circuit (3) de la partie électronique (1) sont réalisés dans la grille estampée (6).

3. Appareil de commande selon la revendication 2,
**caractérisé en ce que**
la mise en contact électrique entre la partie de puissance (2) et la partie électronique (1) se fait par soudage partiel des éléments de contact (9) réalisés dans la grille estampée (6) avec des points de contact correspondants (10) de la plaque de circuit (3).

4. Appareil de commande selon l'une des revendications 1 à 3,
**caractérisé en ce que**
des broches de connexion (11) sont réalisées dans la grille estampée (6) pour au moins un connecteur d'une partie de puissance externe.

5. Utilisation d'un appareil de commande selon l'une des revendications 1 à 4, comme appareil de commande de réseau embarqué d'un véhicule automobile.
